# EUROPEAN PATENT APPLICATION

(11) **EP 4 769 485 A1**
(43) Date of publication of application: **01.07.2026**
(21) Application number: 24872408.0
(22) Date of filing: 26.09.2024
(51) Int. Cl.: H01L 21/52, H01L 23/36

(54) **BONDING FILM, SEMICONDUCTOR MODULE, INVERTER, ELECTRONIC DEVICE, AND METHOD FOR MANUFACTURING SEMICONDUCTOR MODULE**

(30) Priority: 28.09.2023 JP 2023168826
(71) Applicant: Furukawa Electric Co., Ltd., Tokyo 100-8322 (JP)
(72) Inventor: TAKIMOTO Hosei, Tokyo 100-8322 (JP); MIHARA Naoaki, Tokyo 100-8322 (JP); KANEKO Hiroshi, Tokyo 100-8322 (JP)
(74) Representative: Zacco GmbH
(86) International application number: PCT/JP2024/034458
(87) International publication number: WO 2025/070623

(57) **Abstract**

The present invention relates to a bonding film (1) including a metal layer (1b), a first bonding layer (1a) provided on one surface of the metal layer (1b), and a second bonding layer (1a) provided on another surface of the metal layer (1b), in which the metal layer (1b) contains a metal having a thermal conductivity of 100 W/m·K or higher at a temperature of 300 K, and the metal layer (1b) has a 0.2% offset yield strength of 250 MPa or lower.

## Description

### Technical Field

The present invention relates to a bonding film, a semiconductor module using the same, an inverter, an electronic device, and a method for manufacturing a semiconductor module.

### Background Art

Recently, a wide-gap semiconductor, such as SiC or GaN, that operates at a high temperature of 200°C or higher has been attracting attention. As a method for bonding a semiconductor chip element in such a semiconductor, for example, a bonding method called a transient liquid phase sintering method (TLPS method) in which a bonding material containing Cu and Sn is heated at the melting point of Sn or higher and an intermetallic compound containing Cu₆Sn₅ or Cu₃Sn is formed has been proposed (refer to, for example, Patent Literature 1).

In a method for manufacturing a semiconductor module that is disclosed in Patent Literature 1, solder containing Sn is interposed between a first soldering base material containing Cu, which is a bonding surface of a semiconductor chip element, and a second soldering base material containing Cu, which is a bonding surface of a substrate, and heated at a temperature higher than the melting point of Sn, and transient liquid phase sintering of Cu that is contained in each soldering base material and Sn that is contained in the solder is performed, whereby a connection layer including an intermetallic compound copper-tin phase is formed.

However, since the connection layer for bonding a semiconductor chip and the substrate described in Patent Literature 1 is a Cu-Sn intermetallic compound, which is a brittle material, in a case where the semiconductor chip and/or the substrate has repeatedly generated heat and been cooled, it is not possible to sufficiently relax stress that arises from a thermal expansion difference between both, and a crack that traverses the bonding layer from the substrate is generated in the connection layer. Furthermore, when this crack propagates from the substrate up to the semiconductor chip element, there is a concern that the semiconductor chip element, which is an electronic component, may be damaged.

In Patent Literature 2, a bonding sheet in which rolled layers coated with a paste containing Cu and Sn are provided on both surfaces of a core sheet made of Cu or Al, respectively, is disclosed. This bonding sheet is manufactured by applying the paste containing Cu and Sn to both surfaces of the core sheet made of Cu or Al, individually, drying the paste to form dried layers, then, integrally press-molding the dried layers formed on both surfaces of the core sheet and the core sheet to provide rolled layers coated with the paste on both surfaces of the core sheet, individually.

Incidentally, in a case where a semiconductor module has repeatedly undergone on-off operation and a semiconductor chip and/or a substrate has repeatedly generated heat and been cooled, thermal strain stress that is applied to a bonding material becomes large associated with operation at a high temperature, whereby cracks are generated in the bonding material, and there is a concern of the shortening of the element lifetime or an increase in thermal resistance. In the semiconductor module disclosed in Patent Literature 2, the Kovar substrate and the semiconductor chip element are bonded to each other through a bonding layer, and materials to be bonded having a relatively small difference in linear expansion coefficient are used as an electronic component and the substrate. However, in a case where a Cu substrate and a Si chip, which are in common use, are materials to be bonded, it is not possible to relax thermal strain stress that arises from the difference in linear expansion coefficient between both, and cracks are generated in a bonding layer and may cause an increase in thermal resistance or element breakdown.

In Patent Literature 3, a bonding structure including a bonding portion between a first member, such as a semiconductor element, and a second member, such as an electrode or wire of a metal, is disclosed, and in the bonding portion, a bonding layer containing an intermetallic compound of a first metal, such as Ni or Cu, and a second metal, such as Sn, and a notched relaxation layer made of Al or an Al alloy are laminated together. Since the relaxation layer has a notch for inducing cracks into the relaxation layer, the generation of cracks is induced in the relaxation layer, and the generation or propagation of cracks near the bonding portion is inhibited.

In addition, at the time of manufacturing a semiconductor apparatus including semiconductor chips in which a wide band-gap semiconductor element is formed, dicing that divides a semiconductor wafer having an integrated circuit formed thereon into the individual chips is performed. Therefore, there is a desire for development of a bonding material exhibiting favorable dicing performance while relaxing thermal strain stress that arises from the difference in linear expansion coefficient between materials to be bonded.

### Document List

### Patent Literatures

Patent Literature 1: Japanese Patent Application Laid-Open No. 2012-74726
Patent Literature 2: Japanese Patent Application Laid-Open No. 2019-135734
Patent Literature 3: Japanese Patent Application Laid-Open No. 2020-136336

### Summary of Invention

### Technical Problem

It is an object of the present invention to provide a bonding film that prevents the generation of a crack due to thermal strain stress that is applied to the inside and exhibits favorable dicing performance, a semiconductor module using the same, an inverter, an electronic device, and a method for manufacturing a semiconductor module.

### Solution to Problem

A bonding film according to an embodiment of the present invention includes a metal layer, a first bonding layer provided on one surface of the metal layer, and a second bonding layer provided on another surface of the metal layer,
wherein the metal layer contains a metal having a thermal conductivity of 100 W/m·K or higher at a temperature of 300 K, and
the metal layer has a 0.2% offset yield strength of 250 MPa or lower.

A semiconductor module according to an embodiment of the present invention includes the bonding film, a first material to be bonded that is bonded to the first bonding layer, and a second material to be bonded that is bonded to the second bonding layer,
wherein the first material to be bonded is an electronic component, and the second material to be bonded is a metal substrate or a metal lead frame.

An inverter according to an embodiment of the present invention has the semiconductor module mounted thereon.

An electronic device according to an embodiment of the present invention has the inverter mounted thereon.

A method for manufacturing a semiconductor module according to an embodiment of the present invention has a step of bonding an electronic component to a metal substrate or a metal lead frame through the bonding film by heating the electronic component and the metal substrate or the metal lead frame with the bonding film interposed therebetween in an inert atmosphere or a reducing atmosphere at a temperature of 230°C to 350°C for 1 minute to 20 minutes.

### Effects of Invention

According to the present invention, it is possible to provide a bonding film that prevents the generation of a crack due to thermal strain stress that is applied to the inside and exhibits favorable dicing performance, a semiconductor module using the same, an inverter, an electronic device, and a method for manufacturing a semiconductor module.

### Brief Description of Drawings

[Fig. 1] A schematic cross-sectional view showing an example of a dicing die bonding film for which a bonding film of the present invention is used.
[Fig. 2] A schematic cross-sectional view showing an example of a semiconductor module produced using the bonding film of the present invention.
[Fig. 3] A schematic cross-sectional view showing a mounting sample of a semiconductor module produced using a bonding film of Comparative Example 1.

### Description of Embodiments

### [Bonding Film]

A bonding film according to the present invention includes a metal layer, a first bonding layer provided on one surface of the metal layer, and a second bonding layer provided on another surface of the metal layer. That is, the bonding film has a multilayer structure in which the metal layer is provided between the first bonding layer and the second bonding layer, and the metal layer is disposed as a stress-relaxing interlayer. The first bonding layer is provided to be bonded to a first material to be bonded, which will be described below, as one bonding surface of the bonding film, and the second bonding layer is provided to be bonded to a second material to be bonded, which will be described below, as one bonding surface of the bonding film. As described above, the bonding film functions as a bonding material that bonds the first material to be bonded and the second material to be bonded. Since the metal layer having predetermined characteristics has been inserted as an interlayer of the bonding film, for example, in the case of having produced a semiconductor module in which the bonding film is bonded to each material to be bonded having a difference in linear expansion coefficient, such as a semiconductor chip element made of silicon or a copper substrate, thermal strain stress that is applied to the inside of the bonding film and arises from a difference in linear thermal expansion of each material to be bonded, such as the semiconductor chip element or the copper substrate, is adsorbed by the elastic deformation, plastic deformation, or the like of the metal layer even when heat is applied to the bonding film. As a result, it is possible to prevent the generation of cracks in the bonding film and to inhibit the shortening of the element lifetime or an increase in thermal resistance.

### <Metal Layer>

The metal layer contains a metal having a thermal conductivity of 100 W/m·K or higher at a temperature of 300 K. As a result, the building of thermal conductivity and electric condition paths becomes easier than in a structure in which a bonding layer is a single layer, and the thermal conductivity and electric conductivity of the bonding film also improve. Examples of such a metal include copper (Cu), zinc (Zn), aluminum (Al), silver (Ag), gold (Au), magnesium (Mg), aluminum alloys, copper alloys, zinc alloys, and the like, copper (Cu), zinc (Zn), aluminum (Al), aluminum alloys, copper alloys, or zinc alloys are preferable, and copper (Cu), zinc (Zn), or aluminum (Al) is more preferable.

The metal layer has a 0.2% offset yield strength of 250 MPa or lower. As a result, the metal layer is preferentially deformed earlier than the bonding layers that are provided on both surfaces thereof, for example, in the case of having produced a semiconductor module in which the bonding film is bonded to each material to be bonded having a difference in linear expansion coefficient, such as a semiconductor chip element or a substrate, stress that is applied to the inside of the bonding film is relaxed, and the breakdown of the semiconductor module is also prevented. The 0.2% offset yield strength of the metal layer is preferably 250 MPa or lower, more preferably 120 MPa or lower, and still more preferably 50 MPa or lower. On the other hand, the lower limit value of the 0.2% offset yield strength is preferably 5 MPa or higher to also impart certain deformation resistance to the metal layer (to impart certain deformation resistance to secure handleability during manufacturing).

The shape of the metal layer is, for example, a foil shape, a mesh shape, a fiber shape, a pellet shape, or the like and preferably a foil shape. In particular, when a metal foil, in which the shape of the metal layer is a foil shape, is used, it is possible to apply the bonding film even to small and highly reliable power semiconductor modules. In addition, the metal layer may be a metal foil provided with drilled holes or surface unevenness. When a metal foil on which a variety of such processes have been performed is used, since the deformation resistance of the metal layer against elastic deformation, plastic deformation, or the like is reduced, it is possible to further decrease the 0.2% offset yield strength. In addition, the metal layer may be a metal foil softened in advance by a thermal treatment. At that time, the heating temperature is preferably 200°C to 700°C and more preferably 400°C to 600°C. In addition, the heating time is preferably 1 minute to 90 minutes and more preferably 30 minutes to 60 minutes. Furthermore, the metal layer may be a metal foil on which both softening by a thermal treatment and drilling or unevenness processing have been performed.

In addition, in a case where the metal layer is a drilled metal foil, the open hole rate is preferably 5% or more and 70% or less and more preferably 15% or more and 55% or less relative to one surface of the metal foil. Particularly, when the open hole rate is 30% or more and 45%, the 0.2% offset yield strength of the metal layer becomes low, the dicing performance improves, and the thermal conductivity is not significantly damaged. In addition, even in a case where heat has been applied to the metal layer, since it becomes easy for the metal layer to elastically deform or plastically deform, it also becomes easy to prevent the generation of a crack due to thermal strain stress that is applied to the inside of the bonding film, and the reliability of application under high-temperature operation also improves. In addition, the width (opening diameter) of the hole is not particularly limited, but is preferably 0.05 mm or more and 5 mm or less and more preferably 0.1 mm or more and 0.5 mm or less.

The thickness of the metal layer is preferably 8 µm or more and 200 µm or less and more preferably 9 µm or more and 100 µm or less. Particularly, when the thickness of the metal layer is 10 µm or more and 20 µm or less, it becomes easy to process the bonding film, and accordingly the dicing performance improves. In addition, such a bonding film is also effective for application as a bonding film in smaller semiconductor modules.

### <Bonding Layer>

In the bonding film according to the present invention, since the above-described metal layer is interposed between the bonding layers as a stress-relaxing layer, the first bonding layer and the second bonding layer are provided on both surface of the metal layer, respectively. The first bonding layer and the second bonding layer each preferably contain at least one kind of metal particles (P) as a metal component. The materials of the first bonding layer and the second bonding layer, that is, the metal particles (P) that are included in the first bonding layer and the second bonding layer may be each the same as or different from each other but are all preferably the same from the viewpoint of productivity, the connection properties to the metal layer, or the like.

The first bonding layer and the second bonding layer are each preferably a paste layer formed using a paste-like conductive composition. Such a conductive composition contains at least one kind of metal particles (P), a thermosetting resin, a flux, a solvent, and if necessary, may further contain a variety of additives arbitrarily. The first bonding layer and the second bonding layer are produced by the formation of a coated film by the coating of such a paste-like conductive composition or the drying of the coated film.

### (Metal Particles)

In the metal particles (P) as the metal component, for example, the metal particle (P) preferably includes first metal particles (P1) composed of one kind of metal selected from the group consisting of copper (Cu), nickel (Ni), silver (Ag), and gold (Au) or an alloy containing two or more kinds selected from the group of these. Such first metal particles (P1) are excellent in terms of conductivity and thermal conductivity and are thus suitable as the metal particles (P) of a conductive composition to be described below, and in particular, are preferably Cu particles that are inexpensive and excellent in terms of thermal conductivity as well or alloy particles containing Cu.

The metal particles (P) may further include, aside from the above-described first metal particles (P1), second metal particles (P2) having a metal element different from the first metal particles (P1). In this case, it is preferable that the metal particles (P) include the first metal particles (P1) and the second metal particles (P2) and the first metal particles (P1) and the second metal particles (P2) contain metal components capable of forming an intermetallic compound with each other. When the first metal particles (P1) and the second metal particles (P2) contain metals capable of forming an intermetallic compound with each other, it becomes possible for the metal particles (P) as a whole to be a metal or alloy having a low melting point in a non-sintered state and to form an intermetallic compound having a high melting point in a sintered state. As a result, according to such metal particles, it becomes possible to lower the mounting temperature and to exhibit excellent heat resistance with no deterioration of the performances even at temperatures that are the mounting temperature or higher after sintering.

The second metal particle (P2) needs to be a metal element different from the first metal particle (P1) and to contain a metal element capable of forming an intermetallic compound together with the first metal particle (P1). Such a second metal particle (P2) is not particularly limited, but is preferably composed of one kind of metal selected from the group consisting of aluminum (Al), tin (Sn), zinc (Zn), titanium (Ti), indium (In), bismuth (Bi), gallium (Ga), and palladium (Pd) or an alloy containing two or more kinds selected from the group of these. Specifically, for example, in a case where the first metal particle (P1) is a Cu particle, the second metal particle (P2) is preferably a metal particle capable of forming an intermetallic compound together with Cu, for example, a Sn particle or an alloy particle containing Sn.

The combination of the first metal particle (P1) and the second metal particle (P2) capable of forming such an intermetallic compound can be selected as appropriate, but it is preferable that, for example, a Cu-Sn-based, Ni-Sn-based, Ag-Sn-based, Cu-Zn-based, Ni-Zn-based, Ni-Ti-based, or other intermetallic compound can be formed, and in a case where there is a need to set the mounting temperature as low as possible, the second metal particle (P2) preferably contains Sn having a low melting point, and in particular, a Cu-Sn-based combination is more preferable. In order to form such a Cu-Sn-based intermetallic compound, it is preferable that the first metal particle (P1) is a Cu particle and the second metal particle (P2) is a Sn particle or a Sn-based solder particle.

The content of the first metal particles (P1) in each of the first bonding layer and the second bonding layer is preferably 59 mass% or less, more preferably 58 mass% or less, and still more preferably 57 mass% or less. In addition, the lower limit value of the content of the first metal particles (P1) is preferably 54 mass% or more and more preferably 56 mass% or more. When the content of the first metal particles (P1) is 59 mass% or less, the thermal conductivities of the first bonding layer and the second bonding layer further improve. In the first bonding layer and the second bonding layer, the contents of the first metal particles (P1) may be the same as or different from each other.

The content of the second metal particles (P2) in each of the first bonding layer and the second bonding layer is preferably 32 mass% or more and 41 mass% or less and more preferably 35 mass% or more and 37 mass% or less.

In the metal component, it is preferable that Pb (lead), Hg (mercury), Ab (antimony), and As (arsenic) are not substantially contained from the viewpoint of reducing environmental impacts, and the content of these metals is preferably less than 0.1 mass% in total relative to all of the metal components.

The shape of the metal particle (P) is not particularly limited, and a spherical particle, a dendritic particle, a scale shape, a spike shape, or the like can be used as appropriate. In addition, the particle diameter of the metal particle (P) is also not particularly limited, but the average particle dimeter (D50) of the first metal particles (P1) is preferably 15 µm or less, and the average particle dimeter (D50) of the second metal particles (P2) is more preferably 15 µm or less. The average particle dimeter (D50) in the present invention is a value calculated based on measurement by a laser diffraction/scattering-type particle size distribution analysis method.

The content of the metal components that are contained in the conductive composition is preferably 70 to 96 mass% and more preferably 80 to 94 mass%. When the content of the metal components is in such a range, moldability at the time of molding the bonding film improves, handleability as a film is also favorable, and furthermore, excellent conductivity after bonding and sintering can be exhibited.

### (Thermosetting Resin)

The conductive composition contains at least one kind of thermosetting resin as a binder component. When contained in the conductive composition, the thermosetting resin contributes to film properties (ease of molding, ease of handling, or the like) in a non-sintered state at the time of producing the bonding film using the conductive composition and is capable of relaxing stress or the like that is generated between materials to be bonded, which will be described below, for example, an electronic component, such as a semiconductor element, and a metal substrate, a metal lead frame, or the like in a sintered state, by the thermal cycle.

The thermosetting resin preferably contains a maleic acid imide compound including two or more units of imide groups in one molecule from the viewpoint of heat resistance and film properties at the time of mixing the metal particles (P) in particular. Examples of resins containing such a maleic acid imide compound including two or more units of imide groups in one molecule include maleic acid imide resins (hereinafter referred to as "maleimide resins" in some cases). Particularly, since the thermosetting resin containing the maleic acid imide resin is excellent in terms of stress-relaxing properties, it is possible to improve thermal fatigue resistance in the conductive composition after sintering.

The maleic acid imide resin can be obtained by, for example, condensing maleic acid or an anhydride thereof and a diamine or a polyamine. In addition, the maleic acid imide resin preferably includes a skeleton derived from an aliphatic amine having 10 or more carbon atoms from the viewpoint of stress-relaxing properties, and in particular, more preferably has a skeleton that has 30 or more carbon atoms and is represented by the following structural formula (1). In addition, the number-average molecular weight of the maleic acid imide resin is preferably 3000 or more.

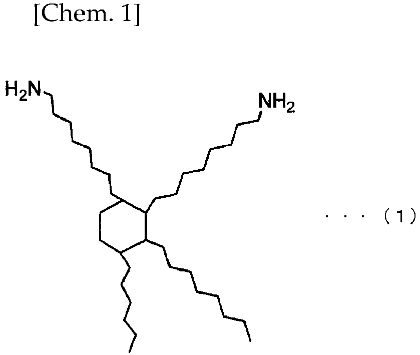

The molecular weight, the glass transition temperature Tg, or the like may be adjusted by including, in the maleic acid imide resin, an acid component other than maleic acids, for example, a skeleton derived from benzene tetracarboxylic acid or an anhydride thereof, hydroxyphthalic acid bis ether or an anhydride thereof, or the like.

As such a maleic acid imide resin, for example, bismaleimide resins indicated by the following structural formulae (2) to (4) and the like are suitably used.

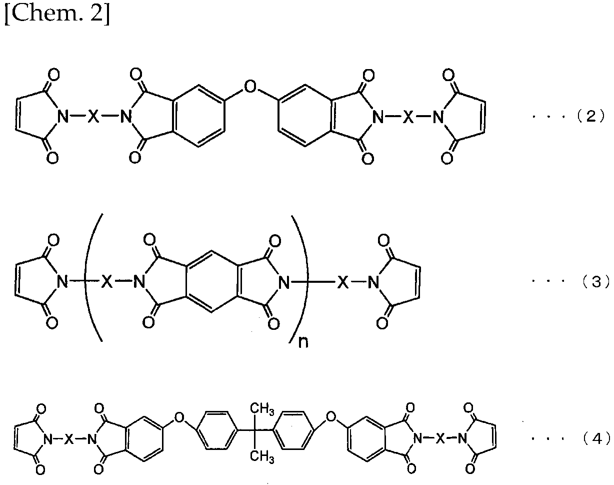

In the formula (3), n is an integer of 1 to 10. In addition, in the formulae (2) to (4), the portion of "X" is "C₃₆H₇₂" represented by the following structural formula (6). In the following formula (5), "*" means the site of bonding to N.

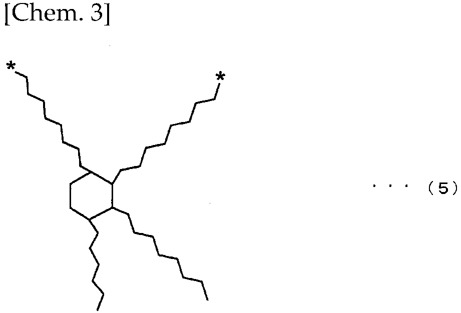

The content of the thermosetting resin that is contained in the conductive composition is preferably 4 mass% or more and 30 mass% or less and more preferably 6 mass% or more and 20 mass% or less. The thermosetting resin may be one kind of thermosetting resin alone, or two or more kinds of thermosetting resins may be used in combination. In addition, if necessary, thermosetting resins other than what has been described above, for example, a phenolic resin, a novolac (phenol and/or cresol), a polyurethane resin, a polyimide resin, a cyanate ester resin, a polyvinyl alcohol resin, a polyester resin, a polyurea resin, a benzoxazine resin, an acrylate resin, a cyanate ester resin, and/or a combination thereof may be further contained.

### (Flux)

The conductive composition may further contain a flux having one or more phosphorus or sulfur bondable to an oxygen atom without accompanying the generation of water in the molecular structure. The flux has a function of removing oxide films on the surfaces of the metal particles (P) that are included in the conductive composition and more effectively acts on, in particular, metals that are likely to oxidize, such as copper, tin, nickel, and aluminum. As such a flux, organic phosphines, sulfide-based compounds, and thiol-based compounds are preferable, and these compounds are extremely resistant to moisture absorption and excellent in terms of moisture absorption resistance compared with fluxes that have been commonly used in the related art, such as carboxylic acids and alcohols.

The flux preferably contains, for example, at least one kind of organic phosphines indicated by the following general formula (6), sulfide-based compounds indicated by the following general formula (7), and thiol-based compounds indicated by the following general formula (8). Here, Rs in the following general formulae (6) and (7) each independently represent an organic group and may be the same as or different from each other.

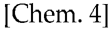

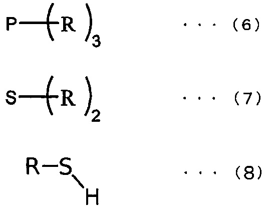

In the general formulae (6), (7), and (8), Rs are, preferably, each independently selected from an alkyl group, an aryl group, an organic group having a functional group, an organic group having a heteroatom, and an organic group having an unsaturated bond, and at least one R is preferably an aryl group.

The alkyl group may be any of liner, branched, and annular and may have a substituent. The alkyl group is preferably linear or branched. In addition, the alkyl group preferably has 3 or more carbon atoms, more preferably has 4 to 18 carbon atoms, and still more preferably has 6 to 15 carbon atoms. Examples of such an alkyl group include a propyl group, a butyl group, a pentyl group, a hexyl group, a heptyl group, an octyl group, a nonyl group, a decyl group, a stearyl group, and an isostearyl group.

The aryl group may have a substituent and preferably has 6 to 10 carbon atoms. Examples of such an aryl group include a phenyl group, a tolyl group, a xylyl group, a cumenyl group, and a 1-naphthyl group.

The organic group having a functional group preferably has 1 to 10 carbon atoms, more preferably 1 to 6 carbon atoms, and still more preferably 1 to 3 carbon atoms. Examples of the functional group include halogen groups, such as a chloro group, a bromo group, and a fluoro group. Examples of the organic group having such a functional group include a chloroethyl group, a fluoroethyl group, a chloropropyl group, a dichloropropyl group, a fluoropropyl group, a difluoropropyl group, a chlorophenyl group, and a fluorophenyl group.

The organic group having a heteroatom preferably has one or more carbon atoms, more preferably has 4 to 18 carbon atoms, and still more preferably has 6 to 15 carbon atoms. Examples of the heteroatom include a nitrogen atom, an oxygen atom, and a sulfur atom. Examples of the organic group having such a heteroatom include a dimethylamino group, a diethylamino group, a diphenylamino group, a methyl sulfoxide group, an ethyl sulfoxide group, and a phenyl sulfoxide group.

The organic group having an unsaturated bond preferably has three or more carbon atoms, more preferably has 4 to 18 carbon atoms, and still more preferably has 6 to 15 carbon atoms. Examples of such an organic group having an unsaturated bond include a propenyl group, a propynyl group, a butenyl group, a butynyl group, an oleyl group, a phenyl group, a vinylphenyl group, and an alkylphenyl group, and among these, a vinylphenyl group is preferable.

In addition, in the general formulae (6), (7), and (8), Rs each independently preferably has any one kind or more selected from a vinyl group, an acrylic group, a methacrylic group, a maleate group, a maleic amide group, a maleimide group, a primary amino group, a secondary amino group, a thiol group, a hydrosilyl group, a hydroboron group, a phenolic hydroxyl group, and an epoxy group in a part thereof. Among these, a vinyl group, an acrylic group, a methacrylic group, a secondary amino group, and a thiol group are more preferable.

The organic phosphines preferably contain, specifically, 4-(diphenylphosphino)styrene. Such compounds have a highly reactive vinyl group and are thus suitable due to low bleed-out.

The sulfide-based compound preferably contains, specifically, at least one kind of bis(hydroxyphenyl) sulfide, bis(4-acryloylthiophenyl) sulfide, 2-methylthiophenothiazine, bis(2-methacryloylthioethyl) sulfide, and bis(4-methacryloylthiophenyl) sulfide and more preferably contains at least one of bis(4-acryloylthiophenyl) sulfide and bis(4-methacryloylthiophenyl) sulfide. Among these compounds, sulfide-based compounds having a highly reactive phenolic hydroxyl group, acrylic group, or methacrylic group are suitable due to low bleed-out, and among them, sulfide-based compounds having an acrylic group or a methacrylic group are most suitable.

The thiol-based compound preferably contains, specifically, at least one kind of 2-dibutylamino-4,6-dimercapto-s-triazine, 2,4,6-trimercapto-s-triazine, 2-pyridinethiol, 2-pyridinemethanethiol, and 3-pyridinemethanethiol. Such a compound has a highly reactive thiol group and is thus suitable due to low bleed-out.

The organic phosphines, the sulfide-based compound, and the thiol-based compound each can also be used singly, but two or more kinds may be used in combination. When the conductive composition contains two or more kinds of the organic phosphines, the sulfide-based compound, and the thiol-based compound as the flux, it is possible to improve the bondability of the bonding film at the time of producing the bonding film using the conductive composition.

In a case where the thermosetting resin contains the maleimide resin, such organic phosphines, sulfide-based compound, and thiol-based compound are capable of forming a copolymer with the maleimide resin and also thus act as a thermosetting resin component. In addition, the organic phosphines, the sulfide-based compound, and the thiol-based compound do not easily absorb moisture, have a sufficiently large molecular weight, and are polymerizable and are thus capable of effectively preventing bleed-out in the case of being used as a flux component. Therefore, when such organic phosphines, sulfide-based compound, and thiol-based compound are used instead of alcohols and carboxylic acids that easily absorb moisture, it is possible to reduce a risk of bleed-out and to guarantee sufficient reliability, in particular, reflow resistance after moisture absorption even when flux washing is not performed.

In addition, the number-average molecular weights of the organic phosphines, the sulfide-based compound, and the thiol-based compound are preferably 260 or more from the viewpoint of inhibiting bleed-out during sintering or the like. When the number-average molecular weights of the organic phosphines, the sulfide-based compound, and the thiol-based compound are 260 or more, and the maleimide resin and these are reacted and cured as described above, it is possible to further reduce bleed-out. As a result, it is possible to prevent contamination of the surfaces of metal substrates, lead frames, and the like due to bleed-out and to improve package reliability.

The content of the organic phosphines that are contained in the conductive composition is preferably 0.5 mass% or more and 10.0 mass% or less and more preferably 1.0 mass% or more and 5.0 mass% or less. When the content of the organic phosphines is controlled to be within the above-described range, the metal oxide film removal capability is sufficiently exhibited.

The content of the sulfide-based compound that is contained in the conductive composition is preferably 0.5 mass% or more and 8.0 mass% or less and more preferably 1.0 mass% or more and 4.0 mass% or less. When the content of the sulfide-based compound is controlled to be within the above-described range, the metal oxide film removal capability is sufficiently exhibited.

The content of the thiol-based compound that is contained in the conductive composition is preferably 0.5 mass% or more and 8.0 mass% or less and more preferably 0.5 mass% or more and 3.0 mass% or less. When the content of the thiol-based compound is controlled to be within the above-described range, the metal oxide film removal capability is sufficiently exhibited.

In a case where the conductive composition contains two or more kinds of the organic phosphines, the sulfide-based compound, and the thiol-based compound as the flux, the total of the contents of these that are contained in the conductive composition is preferably 1.0 mass% or more and 10.0 mass% or less and more preferably 2.0 mass% or more and 5.0 mass% or less.

In addition, the organic phosphines, the sulfide-based compound, and the thiol-based compound may be each used singly, or two or more kinds may be used in combination.

### (Solvent)

The conductive composition contains a solvent, such as cyclopentanone, toluene, or acetone, to adjust the viscosity. The content of the solvent is not particularly limited, but is preferably 0.01 mass% or more and 3 mass% or less and more preferably 0.05 mass% or more and 1.5 mass% or less. The solvent may be used singly, or two or more kinds may be used in combination.

### (Other Components)

The conductive composition may contain, aside from the above-described components, a variety of additive arbitrarily. Such additives can be selected as appropriate, if necessary, and examples thereof include a dispersant, a radical polymerization initiator, a leveling agent, a plasticizer, a curing agent, and the like.

In the case of forming the first bonding layer and the second bonding layer using the above-described conductive composition, mixed layers in which a Cu-Sn intermetallic compound and the cured thermosetting resin are present in a mixed manner may be provided in the interface between the first bonding layer and the metal layer and in the interface between the second bonding layer and the metal layer, respectively. When the dense and highly heat-resistant Cu-Sn intermetallic compound is formed as described above, it is possible to produce a bonding film having a high connection strength.

The thicknesses of the first bonding layer and the second bonding layer are each preferably 10 µm or more and 100 µm or less and more preferably 15 µm or more and 30 µm or less. In addition, the thicknesses of the first bonding layer and the second bonding layer may be the same as or different from each other. In a case where the first bonding layer and the second bonding layer are paste layers formed using a paste-like conductive composition, the thicknesses of the first bonding layer and the second bonding layer mean the thicknesses of dried paste layers.

### (Method for Manufacturing Conductive Composition)

The paste-like conductive composition is manufactured by mixing the metal component including at least one kind of metal particles (P), the thermosetting resin, the flux, the solvent, and if necessary, a variety of additives arbitrarily.

### <Material to be Bonded>

The bonding film according to the present invention is capable of bonding to a material to be bonded, such as an electronic component such as a semiconductor chip or a semiconductor element or a support member such as a metal substrate or a metal lead frame. In such a case, the first bonding layer of the bonding film is bonded to a first material to be bonded, and the second bonding layer of the bonding film is bonded to a second material to be bonded. As a combination of materials to be bonded, for example, the first material to be bonded is an electronic component having a low linear expansion coefficient, such as a semiconductor chip or semiconductor element made of silicon, such as Si or SiC, and the second material to be bonded is a metal substrate or metal lead frame having a high linear expansion coefficient, such as a metal substrate or metal lead frame made of copper or a copper alloy. Since the bonding film according to the present invention has a multilayer structure in which the metal layer is provided between the first bonding layer and the second bonding layer, and the metal layer is disposed as a stress-relaxing interlayer as described above, even in a case where there is a difference in linear expansion coefficient between the first material to be bonded and the second material to be bonded, it is possible to sufficiently relax thermal strain stress that arises from a thermal expansion difference, and as a result, it is possible to prevent the generation of cracks in the bonding film. The combination of the materials to be bonded is not limited to a case where the difference in linear expansion coefficient between the first material to be bonded and the second material to be bonded is large, and even in a case where the difference in linear expansion coefficient between the first material to be bonded and the second material to be bonded is small or a case where there is no difference, it is possible to relax thermal strain stress, and as a result, it is possible to prevent the generation of cracks in the bonding film. Even in a case where the linear expansion coefficients of the first material to be bonded and the second material to be bonded are small, particularly when the difference between the ambient temperature of the first material to be bonded and the ambient temperature of the second material to be bonded is large, a difference in thermal expansion between the first material to be bonded and the second material to be bonded is generated. Even in such a case, it is possible to sufficiently relax thermal strain stress that arises from a thermal expansion difference, and as a result, it is possible to prevent the generation of cracks in the bonding film.

The bonding surfaces of one or both of the first material to be bonded and the second material to be bonded may be coated with a metal. Examples of the metal that coats the bonding surfaces of the materials to be bonded include gold, silver, copper, and nickel. These metals are formed in layers on the bonding surfaces of the materials to be bonded by plating or the like.

### [Method for Manufacturing Bonding Film]

The bonding film according to the present invention was obtained as follows. The conductive composition was stirred with a planetary mixer, then, thinly applied onto a mold-release-treated PEG film, and dried at 80°C to 140°C for 0.5 to 10 minutes to obtain a conductive adhesive film. Subsequently, the obtained conductive adhesive film was laminated onto the metal layer and made to temporarily adhere thereto using a roll heated at 80°C to 140°C. Furthermore, the conductive composition was applied to the surface on the metal layer side and dried at 80°C to 140°C for 0.5 to 10 minutes, and dicing tape was laminated from above, thereby obtaining a bonding film having the metal layer mounted as an interlayer.

The thickness of the bonding film is not particularly limited, but is preferably 10 µm or more and 200 µm or less and more preferably 30 µm or more and 100 µm or less.

The bonding film according to the present invention can be suitably used as a dicing tape-attached bonding film by being laminated with dicing tape. The dicing tape refers to tape that is used in a step of cutting out mainly an integrated circuit, a package, or the like formed on a semiconductor wafer by cutting the semiconductor wafer with a dicing saw and individualizing the integrated circuit, the package, or the like. The bonding film is a form of a dicing die bonding film onto which dicing tape has been laminated, whereby the bonding film and the dicing tape can be laminated onto a semiconductor wafer at once, and it is thus possible to simplify the step.

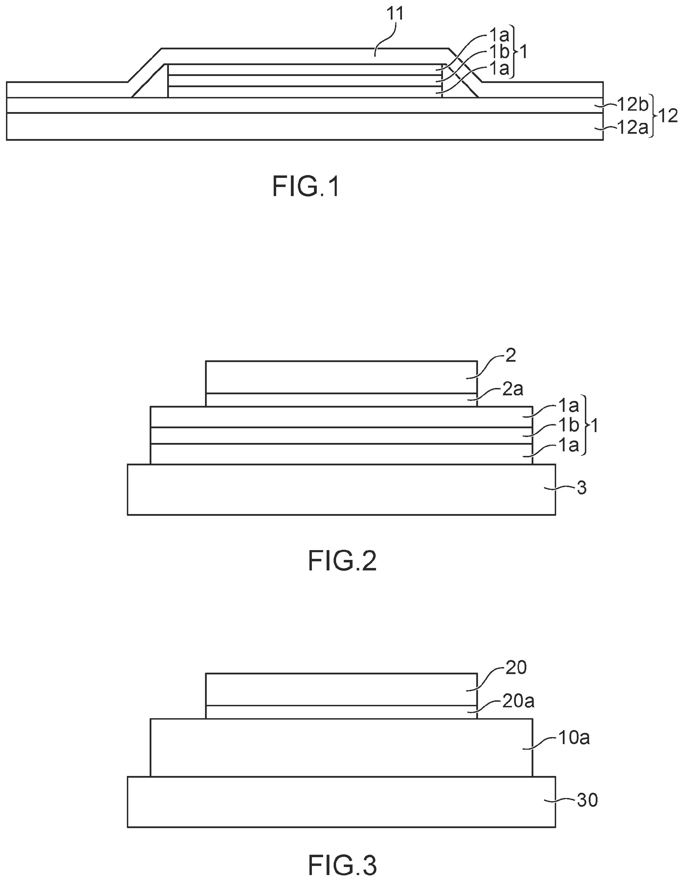

In Fig. 1, the structure of a dicing tape-attached bonding film having a bonding film 1 laminated on dicing tape 12 is shown. The dicing tape 12 has a laminated structure in which a pressure-sensitive adhesive layer 12b is provided on a supporting base material 12a, and the bonding film 1 is provided on a pressure-sensitive adhesive layer 2. A peeling-treated PET film 11 covers the dicing tape 12 and protects the pressure-sensitive adhesive layer 12b or the bonding film 1.

The supporting base material 12a is preferably radiotranslucent, specifically, plastic, rubber, and the like are normally used, and the supporting base material is not particularly limited as long as radiation is transmitted.

A base resin composition of a pressure-sensitive adhesive for the pressure-sensitive adhesive layer 12b is not particularly limited, and a normal radiation-curable pressure-sensitive adhesive is used. Examples of such a radiation-curable pressure-sensitive adhesive include acrylic pressure-sensitive adhesives having a functional group capable of reacting with an isocyanate group, such as a hydroxyl group, and the acrylic pressure-sensitive adhesives preferably has an iodine value of 30 or less and a radiation-curable carbon-carbon double bond structure.

The bonding film 1 according to the present invention includes a metal layer 1b, a first bonding layer 1a provided on one surface of the metal layer 1b, and a second bonding layer 1a provided on another surface of the metal layer as described above and has a laminated structure in which the metal layer 1b is arranged between the two bonding layers 1a.

### [Semiconductor Module]

A semiconductor module according to the present invention includes the above-described bonding film, a first material to be bonded that is bonded to the first bonding layer, and a second material to be bonded that is bonded to the second bonding layer, wherein the first material to be bonded is an electronic component, and the second material to be bonded is a metal substrate or a metal lead frame. Examples of the electronic component include electronic components made of silicon, such as semiconductor chips or semiconductor elements, and examples of the metal substrate or the metal lead frame include metal substrates or metal lead frames made of copper or a copper alloy.

In Fig. 2, an example of a structure of a semiconductor module including the bonding film according to the present invention is shown. The first bonding layer 1a of the bonding film 1 is bonded to a semiconductor chip 2 through a metal-plated layer 2a provided on the bonding surface of the semiconductor chip 2, and the second bonding layer 1a of the bonding film 1 is bonded to a metal lead frame 3.

The semiconductor module according to the present invention is also effective for an application to wide-gap semiconductors that operate at high temperatures of 200°C or higher and can be thus mounted in inverters. In addition, such inverters can also be mounted in EV vehicles, electric railway vehicles, power conditioners, and the like.

### [Method for Manufacturing Semiconductor Module]

A method for manufacturing a semiconductor module according to the present invention has a step of bonding an electronic component to a metal substrate or a metal lead frame through the above-described bonding film by heating the electronic component and the metal substrate or the metal lead frame with the bonding film interposed therebetween in an inert atmosphere or a reducing atmosphere. Examples of the electronic component include electronic components made of silicon, such as semiconductor chips or semiconductor elements, and examples of the metal substrate or the metal lead frame include metal substrates or metal lead frames made of copper or a copper alloy. The inert atmosphere refers to a state of being filled with an inert gas, such as an argon gas or a nitrogen gas, and the reducing atmosphere means a state of being filled with a reducing gas, such as a hydrogen gas. In addition, the heating temperature is preferably 230°C to 350°C, and the heating time is preferably 1 minute to 20 minutes.

Based on the above embodiment, the present invention relates to the following [1] to [10].
[1] A bonding film comprising a metal layer, a first bonding layer provided on one surface of the metal layer, and a second bonding layer provided on another surface of the metal layer, characterized in that
   the metal layer contains a metal having a thermal conductivity of 100 W/m·K or higher at a temperature of 300 K, and
   the metal layer has a 0.2% offset yield strength of 250 MPa or lower.
[2] The bonding film according to [1], wherein the first bonding layer and the second bonding layer each contain at least one kind of metal particles (P), linear expansion coefficient.
[3] The bonding film according to [1] or [2], wherein the metal layer is a metal foil provided with drilled holes or surface unevenness.
[4] The bonding film according to any one of [1] to [3], wherein a thickness of the metal layer is 8 µm or more and 200 µm or less.
[5] The bonding film according to any one of [1] to [4], wherein thicknesses of the first bonding layer and the second bonding layer are each 10 µm or more and 100 µm or less.
[6] The bonding film according to any one of [1] to [5], wherein the first bonding layer and the second bonding layer are paste layers formed using a paste-like conductive composition, and
   the conductive composition contains at least one kind of metal particles (P), a thermosetting resin, a flux, and a solvent.
[7] A semiconductor module comprising the bonding film according to any one of [1] to [6], a first material to be bonded that is bonded to the first bonding layer, and a second material to be bonded that is bonded to the second bonding layer,
   wherein the first material to be bonded is an electronic component, and the second material to be bonded is a metal substrate or a metal lead frame.
[8] An inverter comprising the semiconductor module according to [7] mounted thereon.
[9] An electronic device comprising the inverter according to [8] mounted thereon.
[10] A method for manufacturing a semiconductor module, the method being characterized by comprising a step of bonding an electronic component to a metal substrate or a metal lead frame through the bonding film according to any one of [1] to [6] by heating the electronic component and the metal substrate or the metal lead frame with the bonding film interposed therebetween in an inert atmosphere or a reducing atmosphere at a temperature of 230°C to 350°C for 1 minute to 20 minutes.

Hitherto, the embodiment according to the present invention has been described, but the present invention is not limited to the above-described embodiment, includes all aspects that are included in the concept and claims of the present invention, and can be modified in a variety of manners within the scope of the present invention.

### Examples

Hereinafter, the present invention will be described in more detail based on Examples, but the present invention is not limited to these.

Hereinafter, materials used in individual components will be shown. Unless particularly otherwise described, "%" means "mass%".
· First Metal Particle (P1)
   Cu particle: Fine copper powder (manufactured by Mitsui Mining and Smelting Company, Limited)
   Particle diameter (d50): 5.2 µm
   · Second Metal Particle (P2)
   Sn-Cu-Ni-based solder particle: Trade name "SN100C" (manufactured by Fukuda Metal Foil & Powder Co., Ltd.)
   Particle diameter (d50): 6 µm · Thermosetting resin
   Maleimide resin: Trade name "BMI-3000" (manufactured by Designer Molecules Inc.)
· Flux
   Sulfide-based compound: Trade name "MP SMA" (manufactured by Sumitomo Seika Chemicals Co., Ltd.)
· Solvent
   Cyclopentanone (manufactured by Tokyo Chemical Industry Co., Ltd.)

### · Example 1

### <Production of Conductive Composition>

Among the above-described materials, 57.0 mass% of the Cu particles, 36.4 mass% of the Sn particles, and 6.6 mass% of other components (a thermosetting resin, the flux, the solvent, a curing agent, and the like) were mixed together to produce a paste-like conductive composition (hereinafter also referred to as "paste material").

### <Bonding Film>

The produced paste material was thinly applied onto a mold-release-treated PET film and dried at 120°C in a nitrogen atmosphere. Next, an electrolytic Cu foil (thickness: 100 µm) softened in advance by a thermal treatment at 600°C for 60 minutes was laminated onto the dried paste material (paste layer) and then made to temporarily adhere thereto using a roll heated at 90°C. Furthermore, the paste material was applied to the surface on the Cu foil side and dried at 120°C in a nitrogen atmosphere. Furthermore, dicing tape was laminated onto the dried paste material (paste layer), and a bonding film having a structure as shown in Fig. 1 was produced.

### <Semiconductor Module>

The PET film of the produced bonding film was peeled off, a Si wafer (0.2 mmt) was laminated onto the surface of an exposed bonding layer and then diced with a dicing blade, and semiconductor chips were manufactured. In this dicing step, the number of times of chip flying of the semiconductor chips occurring per 8 inch wafer was counted. This was used as an evaluation item of "dicing performance" to be described below. After that, the bonding film to which the semiconductor chips were bonded was peeled off from the dicing tape, the surface of the exposed bonding layer was disposed on a Cu substrate, preliminarily heated at 150°C in a nitrogen atmosphere, and then further fired at 280°C, and mounting samples of a semiconductor module having a structure shown in Fig. 2 were produced.

### <Dicing Performance>

The dicing performance was evaluated as described below. The result is shown in Table 1.
· Excellent: Less than 1% of chip flying
· Good: 1% or more and less than 3% of chip flying
· Fair: 3% or more and less than 10% of chip flying
· Poor: 10% or more of chip flying

### <Shear Hardness>

Thermal shock tests (TCTs) were performed at -45°C to +200°C on, among the produced mounting samples, samples that could be mounted with no chip flying, and the bonding states were evaluated by shear tests after 1000 cycles. Specifically, the shear strengths after TCTs were measured at a testing speed of 50 µm/s with a substrate/jig clearance of 0.05 mm and evaluated as described below. When the evaluation of the shear strength was "Fair" or higher, it was evaluated that the generation of a crack due to thermal strain stress that was applied to the inside was prevented. The result is shown in Table 1.
· Excellent: The shear strength is 35 MPa or higher
· Good: The shear strength is 25 MPa or higher and lower than 35 MPa
· Fair: The shear strength is 15 MPa or higher and lower than 25 MPa
· Poor: The shear strength is lower than 15 MPa

### · Example 2

The same operation as in Example 1 was performed except that the thickness of the Cu foil that was used in the bonding film was changed to 35 µm and the paste material was dried so that the thickness of the dried paste material (paste layer) reached the thickness shown in Table 1. The result is shown in Table 1.

### · Example 3

The same operation as in Example 1 was performed except that the thickness of the Cu foil that was used in the bonding film was changed to 18 µm and the paste material was dried so that the thickness of the dried paste material (paste layer) reached the thickness shown in Table 1. The result is shown in Table 1.

### · Example 4

The same operation as in Example 1 was performed except that the Cu foil that was used in the bonding film was changed to a drilled electrolytic Cu foil having an open hole with a diameter of 0.35 mm (thickness: 15 µm, open hole rate: 17%) and the paste material was dried so that the thickness of the dried paste material (paste layer) reached the thickness shown in Table 1. The result is shown in Table 1.

### · Example 5

The same operation as in Example 1 was performed except that the Cu foil that was used in Example 4 was changed to a drilled Cu foil having an open hole rate of 32% and the paste material was dried so that the thickness of the dried paste material (paste layer) reached the thickness shown in Table 1. The result is shown in Table 1.

### · Example 6

The same operation as in Example 1 was performed except that the Cu foil that was used in the bonding film used in Example 4 was further softened in advance by a thermal treatment at 600°C for 60 minutes and the paste material was dried so that the thickness of the dried paste material (paste layer) reached the thickness shown in Table 1. The result is shown in Table 1.

### · Example 7

The same operation as in Example 1 was performed except that the Cu foil that was used in the bonding film used in Example 6 was changed to a drilled Cu foil having an open hole rate of 32% and the paste material was dried so that the thickness of the dried paste material (paste layer) reached the thickness shown in Table 1. The result is shown in Table 1.

### · Example 8

The same operation as in Example 1 was performed except that the paste material was applied and dried using the Cu foil that was used in the bonding film used in Example 7 so that the thickness of the dried paste material (paste layer) reached the thickness shown in Table 1. The result is shown in Table 1.

### · Example 9

The same operation as in Example 1 was performed except that the paste material was applied and dried using the Cu foil that was used in the bonding film used in Example 7 so that the thickness of the dried paste material (paste layer) reached the thickness shown in Table 1. The result is shown in Table 1.

### · Example 10

The same operation as in Example 1 was performed except that the Cu foil that was used in the bonding film was changed to a Zn foil (thickness: 56 µm) and the paste material was dried so that the thickness of the dried paste material (paste layer) reached the thickness shown in Table 1. The result is shown in Table 1.

### · Example 11

The same operation as in Example 1 was performed except that the Cu foil that was used in the bonding film was changed to an Al foil (thickness: 85 µm) and the paste material was dried so that the thickness of the dried paste material (paste layer) reached the thickness shown in Table 1. The result is shown in Table 1.

### · Comparative Example 1

The same operation as in Example 1 was performed except that the paste material produced in Example 1 was applied onto a mold-release-treated PET film and dried at 120°C in a nitrogen atmosphere, furthermore, dicing tape was laminated onto the paste material (paste layer), and a bonding film having a structure as shown in Fig. 3 was produced. The result is shown in Table 1.

### · Comparative Example 2

The same operation as in Example 1 was performed except that the Cu foil that was used in the bonding film was changed to a Cu foil that was not softened by a thermal treatment (thickness: 50 µm) and the paste material was dried so that the thickness of the dried paste material (paste layer) reached the thickness shown in Table 1. The result is shown in Table 1.

### · Comparative Example 3

The same operation as in Example 1 was performed except that the Cu foil that was used in the bonding film was changed to a notched Cu foil that was not softened by a thermal treatment (thickness: 100 µm) and the paste material was dried so that the thickness of the dried paste material (paste layer) reached the thickness shown in Table 1. The result is shown in Table 1.

**[Table 1]**

| | Structure of bonding film | | | | | | | | | | | | Evaluation item | |
|---|---|---|---|---|---|---|---|---|---|---|---|---|---|---|
| | Metal layer | | | | | Bonding layer | | | | | | Total | Dicing performance | Shear strength after TCT |
| | Metal kind | Thermal treatment | Shape processing | Thickness | 0.2% offset yield strength | Cu | Sn | Other components | Paste material single surface coating thickness | Thickness of paste material after drying | | Thickness | | |
| | | | | | | | | | | First bonding layer | Second bondina laver | | | |
| | | | | µm | MPa | mass% | mass% | mass% | µm | µm | µm | µm | | |
| Example 1 | Cu | Good | Foil | 100 | 60 | 57.0 | 364 | 6.6 | 40 | 23 | 20 | 143 | Good | Good |
| Example 2 | Cu | Good | Foil | 35 | 60 | 57.0 | 364 | 6.6 | 40 | 22 | 22 | 79 | Good | Good |
| Example 3 | Cu | Good | Foil | 18 | 60 | 57.0 | 364 | 6.6 | 40 | 22 | 22 | 62 | Good | Good |
| Example 4 | Cu | Poor | Drilling, open hole rate 17% | 15 | 225 | 57.0 | 364 | 6.6 | 40 | 21 | 22 | 58 | Fair | Good |
| Example 5 | Cu | Poor | Drilling, open hole rate 32% | 15 | 88 | 57.0 | 364 | 6.6 | 40 | 22 | 23 | 60 | Good | Good |
| Example 6 | Cu | Good | Drilling, open hole rate 17% | 15 | 106 | 57.0 | 364 | 6.6 | 40 | 22 | 20 | 57 | Good | Good |
| Example 7 | Cu | Good | Drilling, open hole rate 32% | 15 | 30 | 57.0 | 364 | 6.6 | 40 | 20 | 19 | 54 | Excellent | Excellent |
| Example 8 | Cu | Good | Drilling, open hole rate 32% | 15 | 30 | 57.0 | 364 | 6.6 | 75 | 41 | 38 | 94 | Excellent | Excellent |
| Example 9 | Cu | Good | Drilling, open hole rate 32% | 15 | 30 | 57.0 | 364 | 6.6 | 25 | 15 | 14 | 44 | Excellent | Excellent |
| Example 10 | Zn | Poor | Foil | 56 | 22 | 57.0 | 364 | 6.6 | 40 | 20 | 20 | 96 | Excellent | Good |
| Example 11 | Al | Poor | Foil | 85 | 22 | 57.0 | 364 | 6.6 | 40 | 20 | 21 | 126 | Excellent | Good |
| Comparative Example 1 | - | - | - | - | - | 57.0 | 364 | 6.6 | 100 | 57 | | 57 | Excellent | Poor |
| Comparative Example 2 | Cu | Poor | Foil | 50 | 265 | 57.0 | 364 | 6.6 | 40 | 23 | 22 | 95 | Poor | Fair |
| Comparative Example 3 | Cu | Poor | (Notched) foil | 100 | 265 | 57.0 | 364 | 6.6 | 40 | 22 | 23 | 145 | Poor | Fair |

As shown in Table 1, in Examples 1 to 3, 5, and 6, the obtained bonding films exhibited excellent dicing performances. In addition, the bonding films were also excellent in terms of the shear strength after TCT, and it was also possible to prevent the generation of a crack due to thermal strain stress that was applied to the inside.

In Example 4, the obtained bonding film exhibited favorable dicing performance. In addition, the bonding film was also excellent in terms of the shear strength after TCT, and it was also possible to prevent the generation of a crack due to thermal strain stress that was applied to the inside.

In Examples 7 to 9, the obtained bonding films exhibited extremely excellent dicing performance. In addition, the bonding films were also extremely excellent in terms of the shear strength after TCT, and it was also possible to prevent the generation of a crack due to thermal strain stress that was applied to the inside.

In Examples 10 and 11, the obtained bonding films exhibited extremely excellent dicing performance. In addition, the bonding films were also excellent in terms of the shear strength after TCT, and it was also possible to prevent the generation of a crack due to thermal strain stress that was applied to the inside.

On the other hand, in Comparative Example 1 where a bonding film having no metal layers was used, excellent dicing performance was exhibited, but the shear strength after TCT was low, and it was not possible to prevent the generation of a crack due to thermal strain stress that was applied to the inside.

In addition, in Comparative Example 3 where a bonding film in which a hard Cu foil having a high 0.2% offset yield strength that was not softened by a thermal treatment was interposed as a metal layer was used, the shear strength after TCT was favorable, and it was possible to prevent the generation of a crack due to thermal strain stress that was applied to the inside, but dicing performance was poor.

In Comparative Example 4 where a bonding film in which a notched hard Cu foil having a high 0.2% offset yield strength that was not softened by a thermal treatment was interposed as a metal layer was used, the shear strength after TCT was favorable, and it was possible to prevent the generation of a crack due to thermal strain stress that was applied to the inside, but dicing performance was poor.

As described above, in the bonding film according to the present invention, a metal layer having predetermined characteristics is inserted as an interlayer, and bonding layers in which a predetermined metal is contained in a certain content are provided on both surfaces of the metal layer, whereby it is possible to provide a bonding film exhibiting favorable dicing performance while preventing the generation of a crack due to thermal strain stress that is applied to the inside and a semiconductor module using the same. In addition, provision of an inverter having such a semiconductor module mounted thereon and an electronic device having such an inverter mounted thereon is also possible.

### List of Reference Signs

1 bonding film,
1a first bonding layer, second bonding layer,
1b metal layer,
2 semiconductor chip,
2a metal-plated layer,
3 metal lead frame,
11 peeling-treated PET,
12 dicing tape,
12a supporting base material,
12b pressure-sensitive adhesive layer

## Claims

1. A bonding film comprising a metal layer, a first bonding layer provided on one surface of the metal layer, and a second bonding layer provided on another surface of the metal layer, **characterized in that**
the metal layer contains a metal having a thermal conductivity of 100 W/m·K or higher at a temperature of 300 K, and
the metal layer has a 0.2% offset yield strength of 250 MPa or lower.

2. The bonding film according to claim 1, wherein the first bonding layer and the second bonding layer each contain at least one kind of metal particles (P).

3. The bonding film according to claim 1 or 2, wherein the metal layer is a metal foil provided with drilled holes or surface unevenness.

4. The bonding film according to claim 1 or 2, wherein a thickness of the metal layer is 8 µm or more and 200 µm or less.

5. The bonding film according to claim 1 or 2, wherein thicknesses of the first bonding layer and the second bonding layer are each 10 µm or more and 100 µm or less.

6. The bonding film according to claim 1 or 2, wherein the first bonding layer and the second bonding layer are paste layers formed using a paste-like conductive composition, and
the conductive composition contains at least one kind of metal particles (P), a thermosetting resin, a flux, and a solvent.

7. A semiconductor module comprising the bonding film according to claim 1 or 2, a first material to be bonded that is bonded to the first bonding layer, and a second material to be bonded that is bonded to the second bonding layer,
wherein the first material to be bonded is an electronic component, and the second material to be bonded is a metal substrate or a metal lead frame.

8. An inverter comprising the semiconductor module according to claim 7 mounted thereon.

9. An electronic device comprising the inverter according to claim 8 mounted thereon.

10. A method for manufacturing a semiconductor module, the method being **characterized by** comprising a step of bonding an electronic component to a metal substrate or a metal lead frame through the bonding film according to claim 1 or 2 by heating the electronic component and the metal substrate or the metal lead frame with the bonding film interposed therebetween in an inert atmosphere or a reducing atmosphere at a temperature of 230°C to 350°C for 1 minute to 20 minutes.
